# EUROPEAN PATENT APPLICATION

(11) **EP 3 687 010 A1**
(43) Date of publication of application: **29.07.2020**
(21) Application number: 19153235.7
(22) Date of filing: 23.01.2019
(51) Int. Cl.: H01S 5/026, G02B 1/02, H01L 31/0232, H01L 31/105, H01L 33/00, H01S 5/0683, H01S 5/183, G02B 19/00, G02B 27/09, H01S 5/022

(54) **OPTICAL COMPONENT, LIGHT SOURCE DEVICE, OPTICAL SENSOR DEVICE AND METHOD OF MANUFACTURING AN OPTICAL COMPONENT**

(71) Applicant: Koninklijke Philips N.V., 5656 AG Eindhoven (NL)
(72) Inventor: WEIGL, Alexander, 5656 AE Eindhoven (NL)
(74) Representative: Witte, Weller & Partner Patentanwälte mbB

(57) **Abstract**

The present invention relates to an optical component comprising a component substrate (18) of semiconductor material. The component substrate (18) is at least partially transparent for light in an operational spectral range. The optical component further comprises a photodiode layer structure (20) monolithically integrated with the component substrate (18). The photodiode layer structure is transparent in the operational spectral range. Further, a light source device having such optical component, an optical sensor device and a method of manufacturing the optical component are disclosed.

## Description

### FIELD OF THE INVENTION

The present invention relates to an optical component. The optical component may be used in a light source device. The invention further relates to a light source device having an optical component. The light source device may be used in an optical sensor device, e.g. an optical sensor device for measuring distances, velocities etc. The invention also relates to an optical sensor device equipped with a light source device. Further, the invention relates to a method of manufacturing an optical component.

### BACKGROUND OF THE INVENTION

Optical components like lenses, diffusors and diffractive optics may be situated in the optical beam path of active optical devices like laser diodes and may significantly influence the optical properties of such optical devices. For example, optical components like diffusors provide eye safety of large laser array components. Diffractive optics may direct a light beam into desired directions. Lenses may converge or diverge a light beam. Partial or even complete damage or drop of these optical components leads to an impairment of the system, and in some instances may lead to an endangering of the users of such systems. Thus, there may be a need for a permanent monitoring that the beam path through an optical component is not interrupted.

From DE 10 2005 016 052 A1 a self-monitoring light source is known which comprises a light monitoring device which receives a part of the light emitted by the light source. An optical component is provided which is partially transparent and partially reflective to the light emitted by the light source, wherein the reflected light is re-directed to the light monitoring device. The light monitoring device comprises a photo detector which receives the re-directed light and thus is enabled to monitor the presence of the optical component.

### SUMMARY OF THE INVENTION

It is an object of the invention to provide an optical component, the presence and/or integrity of which can be monitored with low structural complexity.

It is a further object of the invention to provide a light source device comprising such an optical component.

It is a further object of the present invention to provide an optical sensor device comprising a light source device and such an optical component.

Further, it is an object of the invention to provide a method of manufacturing such an optical component.

According to an aspect of the invention, an optical component is provided, comprising
a component substrate of semiconductor material, the component substrate being at least partially transparent for light in an operational spectral range, and
a photodiode layer structure monolithically integrated with the component substrate and being transparent in the operational spectral range.

The invention is based on the idea to merge an optical component and a light monitoring device in a single component. This single component has an optical property to influence a light beam and a monitoring property to monitor whether a light beam through the optical component is impaired or even interrupted. According to the principles of the present invention, the optical component comprises a component substrate of semiconductor material. The component substrate is at least partially transparent for light in an operational spectral range, e.g. light in the near infrared or infrared spectral range. Light in the operational spectral range thus may pass through the component substrate. A photodiode layer structure is monolithically integrated with the component substrate. The photodiode layer structure is transparent in the operational spectral range. A light beam thus may pass through the photodiode layer structure. Light passing through the photodiode layer structure generates a photodiode current in the photodiode layer structure which may be measured, and thus it may be determined whether light passes through the optical component or not. It is also possible to measure the amount of light passing through the optical component so that a damage or deterioration of the optical component can be detected. The optical component with integrated photodiode layer structure thus not only has an optical function of influencing a light beam like collimating, collecting or diffusing the light beam, but also the function of detecting the presence and proper function of itself. The presence and integrity of the optical component thus can be monitored with low structural complexity.

Manufacturing of the optical component is very cost-effective as manufacturing of the optical component including the integration of the photodiode layer structure can be performed with the same manufacturing equipment conventionally used for forming the component substrate itself.

The photodiode layer structure may be adapted to the optical properties of the optical component. For example, the photodiode layer structure may have a shape which is a lens surface shape, a grating surface shape or a diffuser surface shape. The optical function of the optical component, like collimation, collecting, diverging, diffracting or diffusing of light may be at least partially conferred to the optical component by the photodiode layer structure. In other embodiments, the photodiode layer structure may be such that it does not or as little as possible influence the beam path of the light emitted by the light emitting device, meaning that the photodiode layer does not have any effect on beam path direction.

The component substrate typically has a light entrance side and a light exit side. The photodiode layer structure may be monolithically integrated with the component substrate on one of the light exit side and the light entrance side of the component substrate. In this way, manufacturing the optical component with monolithically integrated photodiode layer structure may be performed in a cost-effective way. For example, the photodiode layer structure may be grown or deposited on the component substrate by any known method like epitaxial growth, vapor deposition techniques and the like. Preferentially, the photodiode layer structure is monolithically integrated on the light exit side of the component substrate. After forming the photodiode layer structure on the raw component substrate, both the component substrate and the photodiode layer structure may be etched in order to provide the optical component with the desired surface shape, depending on the optical function of the optical component to be obtained. The photodiode layer structure thus is merged with the component substrate.

The photodiode layer structure may exhibit a curved lens surface shape on the one of the light entrance side and the light exit side of the component substrate. Such a curved lens surface shape may be convex, concave, or may have convex and concave surface portions, and may be spherical or aspherical.

In an alternative, the photodiode layer structure may exhibit a diffractive grating surface shape or a diffusor surface shape on the one of the light entrance side and the light exit side of the component substrate. The diffractive grating surface shape may comprise grooves and ridges. When manufacturing the optical component, the component substrate may be provided with the diffractive grating surface shape on the light exit side, and the photodiode layer structure may be formed on the grating surface subsequently. It is also possible to first grow or deposit the photodiode layer structure with the component substrate and to subsequently work, e.g. etch the diffractive grating surface shape into the component-photodiode layer-compound.

Generally, the photodiode layer structure may be formed on the component substrate by growing or deposition according to any suitable technique.

Preferentially, the photodiode layer structure comprises the semiconductor material of the component substrate. The semiconductor material may comprise a compound semiconductor material. Examples for compound semiconductor materials suitable for the optical component according to the present invention are II-VI or III-V compound semiconductor materials.

A compound semiconductor material may comprise GaAs including compounds comprising GaAs, for example InGaAs, AlGaAs.

Preferentially, the photodiode layer structure is a thin film structure. A thin film structure keeps undesired absorption losses in the light beam passing through the photodiode layer structure as low as possible. The photodiode layer structure may comprise a p-n or p-i-n layer structure, e.g. a p-doped AlGaAs layer, and an n-doped AlGaAs layer, with or without an intrinsic AlGaAs layer therebetween.

According to a second aspect, a light source device is provided, comprising a light emitting device configured to emit light in an operational spectral range, an optical component according to the first aspect, wherein the optical component is arranged to receive and transmit light emitted by the light emitting device, wherein the photodiode layer structure is arranged such with respect to the light emitting device that light emitted by the light emitting device passes through the photodiode layer structure.

The photodiode layer structure of the optical component is operable to measure whether and in which amount light emitted by the light emitting device passes through the optical component. The operational spectral range may comprise one or more wavelengths in a range from 700 nm to 1600 nm.

The light emitting device may be a laser diode, in particular a Vertical Cavity Surface Emitting Laser (VCSEL).

The light source device may comprise a plurality of light emitting devices, e.g. an array of VCSELs and a plurality of optical components each with integrated photodiode layer structure.

According to a third aspect, an optical sensor device is provided, comprising a light source device according to the second aspect.

Such an optical sensor device may be a distance sensor, a velocity sensor, a particle detecting sensor etc.

According to a fourth aspect, a method of manufacturing an optical component is provided, comprising
providing a component substrate of semiconductor material, the component substrate being at least partially transparent for light in an operational spectral range, and
monolithically integrating a photodiode layer structure with the component substrate, wherein the photodiode layer structure is transparent in the operational spectral range.

The step of monolithically integrating the photodiode layer structure may comprise forming the photodiode layer structure on the component substrate and etching the photodiode layer structure, and optionally the component substrate, to a desired shape of a surface of the optical component, wherein the desired shape may depend on the optical function of the optical component to be obtained. This embodiment is particularly suitable in case of an optical component with integrated photodiode layer structure in lens shape.

Alternatively, the optical component may be shaped into the desired shape depending on the desired optical function of the optical component, and then the photodiode layer structure is formed on the component substrate such that the photodiode layer structure conforms to the surface shape of the component substrate.

The light source device of the second aspect, the optical sensor device of the third aspect and the method of the fourth aspect have the same embodiments and advantages as the optical component of the first aspect.

### BRIEF DESCRIPTION OF THE DRAWINGS

These and other aspects of the invention will be apparent from and elucidated with reference to the embodiments described hereinafter. In the following drawings:
Fig. 1 shows a sketch of a light source device comprising an optical component with integrated photodiode layer structure;
Fig. 2 shows an embodiment of an optical component with integrated photodiode layer structure;
Fig. 3 shows the optical component in Fig. 2 in a manufacturing step;
Fig. 4 shows another embodiment of an optical component with integrated photodiode layer structure;
Fig. 5 shows another embodiment of an optical component with integrated photodiode layer structure;
Fig. 6 shows an embodiment of a plurality of optical components each with integrated photodiode layer structure;
Fig. 7 shows a sketch of an optical sensor device; and
Fig. 8 shows a flowchart of a method of manufacturing an optical component.

### DETAILED DESCRIPTION OF THE INVENTION

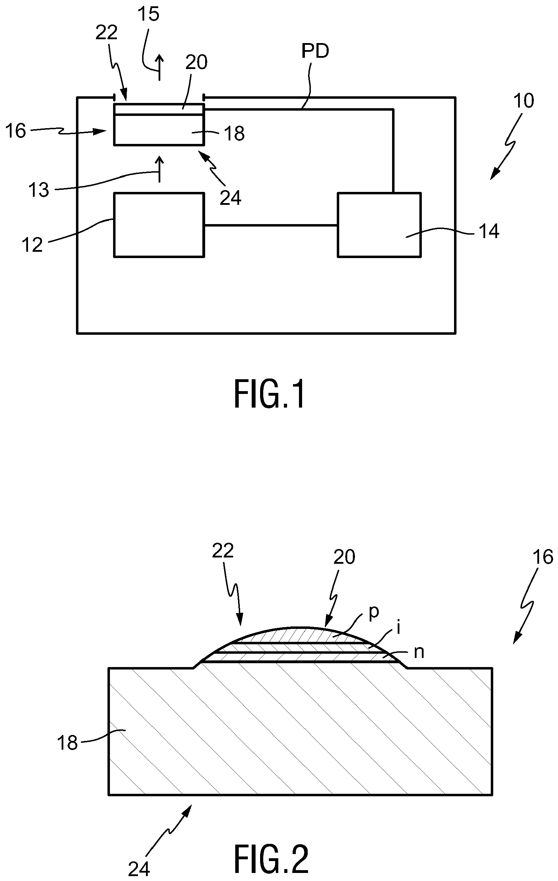

Fig. 1 shows a sketch of a light source device labeled in its entirety with reference numeral 10. The light source device 10 comprises a light emitting device 12. The light emitting device 12 is configured to emit light indicated by an arrow 13 in an operational spectral range. The operational spectral range may comprise one or more wavelengths in a spectral range from 700 nm to 1600 nm.

The light emitting device 12 may be a laser diode, in particular a Vertical Cavity Surface Emitting Laser (VCSEL).

The light source device 10 further comprises a driving circuit 14 configured to drive the light emitting device 12. In case the light emitting device 12 is a laser diode, in particular a VCSEL, the driving circuit 14 supplies a driving current to the light emitting device 12 to trigger light emission by the laser diode.

The light source device 10 further comprises an optical component 16. The optical component 16 is arranged to receive light (arrow 13) emitted by the light emitting device 12 and to transmit the light, as indicated by an arrow 15. Thus, light emitted by the light emitting device 12 passes through the optical component 16.

The optical component 16 may be a lens with positive or negative power. The lens may converge or diverge a light beam passing through the optical component 16.

In other embodiments, the optical component 16 may be configured as a diffractive grating or as a diffusor, depending on the application of a system, in which the light source device 10 is used.

The optical component 16 comprises a component substrate 18 and a photodiode layer structure 20 as will be described below.

The component substrate 18 comprises a semiconductor material. The component substrate 18 may be made in its entirety of the semiconductor material, or may comprise further materials besides the semiconductor material. The semiconductor material may be a II-VI or III-V compound semiconductor material. For example, the component substrate 18 may comprise GaAs, InGaAs or AlGaAs.

The component substrate 18 is at least partially transparent for light in the operational spectral range of the light emitted by the light emitting device 12. For example, GaAs is transparent for light in the near infrared and infrared spectral range.

The photodiode layer structure 20 is monolithically integrated with the component substrate 18. The photodiode layer structure 20 is transparent in the operational spectral range of the light emitted by the light emitting device 12.

In Fig. 1, the photodiode layer structure 20 is shown to be monolithically integrated with the component substrate 18 on a light exit side 22 of the component substrate 18. In other embodiments, the photodiode layer structure 20 may be monolithically integrated with the component substrate 18 on a light entrance side 24 of the component substrate 18. In other embodiments, the photodiode layer structure 20 may be monolithically integrated within the component substrate 18 between the light entrance side 24 and the light exit side 22.

Fig. 2 shows a more detailed embodiment of the optical component 16. In the embodiment in Fig. 2, the photodiode layer structure 20 exhibits a curved lens surface shape on the light exit side 22 of the component substrate 18. The component substrate 18 may comprise GaAs as the semiconductor material. The photodiode layer structure 20 is grown or deposited on the component substrate 18. The photodiode layer structure is a p-i-n thin film structure in this embodiment. Contacts for electrically contacting the photodiode layer structure 20 are omitted in Fig. 2.

The p-i-n structure of the photodiode layer structure 20 may comprise p-doped AlGaAs as the p-layer, undoped AlGaAs as the i-layer, and n-doped AlGaAs as the n-layer.

In other embodiments, the photodiode layer structure may be configured as a p-n layer structure.

In the embodiment in Fig. 2, the curved lens surface shape of the photodiode layer structure 20 is a convex lens surface shape. In other embodiments, the photodiode layer structure 20 may exhibit a concave lens surface shape.

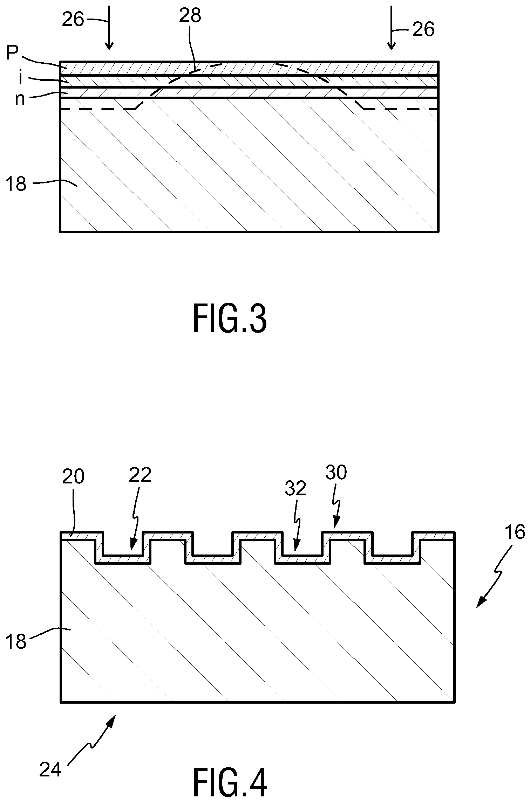

The optical component 16 may be manufactured according to Fig. 3 by growing or depositing the n-, i-, and p-layer on the component substrate 18 with a suitable process, for example by epitaxially growing the photodiode layer structure 20 on the component substrate 18, or by depositing the photodiode layer structure 20 by a chemical or physical vapor deposition technique on the component substrate 18. After having formed the p-i-n layer structure 20 on the component substrate 18, the photodiode layer structure 20 may be etched as indicated by arrows 26 until the surface contour of the photodiode layer structure 20 shown with a broken line 28 of the optical component 16 according to Fig. 2 is obtained.

Fig. 4 shows a further embodiment of the optical component 16 configured as a diffractive grating. The diffractive grating comprises ridges 30 and grooves 32 in an alternating arrangement. In this embodiment, the photodiode layer structure 20 (shown as a single layer for the sake of simplicity) exhibits a diffractive grating surface shape on the light exit side 22 of the component substrate 18. The optical component 16 in Fig. 4 maybe manufactured by providing the component substrate 18 with the grooves 32 and ridges 30 worked into the component substrate 18 beforehand, and subsequently growing or depositing the photodiode layer structure 20 onto the surface 22 of the component substrate 18. It is also possible to first grow or deposit the photodiode layer structure 20 with the component substrate 18 and to subsequently work, e.g. etch the diffractive grating surface shape into the component-photodiode layer-compound to generate the grooves 32 and ridges 30.

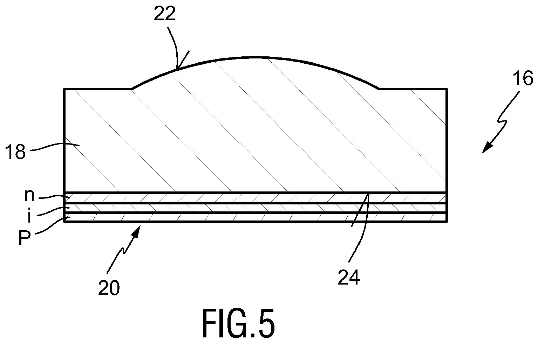

Fig. 5 shows another embodiment of the optical component 16, wherein differently from the embodiment in Fig. 2, the photodiode layer structure 20 is monolithically integrated with the component substrate 18 on the light entrance side 24 of the optical component 18.

In all embodiments described before, and with reference to Fig. 1 again, the photodiode layer structure 20 is arranged and configured to measure light emitted by the light emitting device 12 and passing through the photodiode layer structure 20. Thus, since the photodiode layer structure 20 is monolithically integrated with the component substrate 18, the presence and/or integrity of the optical component 16 can be monitored. The light passing through the photodiode layer structure 20 generates a photodiode current PD in the photodiode layer structure 20, which may be fed, for example, to the driving circuit 14 or another circuit for evaluation. The measured photodiode current PD may be used to monitor the presence and integrity of the optical component 16. In case of a damage and/or loss of the optical component 16, the photodiode current PD is reduced or diminishes which may be detected by the driving circuit 14 or an evaluation circuit. The measured photodiode current PD may also be used to trigger a function of the light emitting device 12. For example, in case the photodiode current PD measured by the photodiode layer structure 20 vanishes, the driving circuit 14 may switch off the light emitting device 12 by shutting down the laser diode drive current, if eye safety of a user is to be ensured. In other embodiments, the driving current of the light emitting device 12 may be increased or decreased dependent on the measured photodiode current PD.

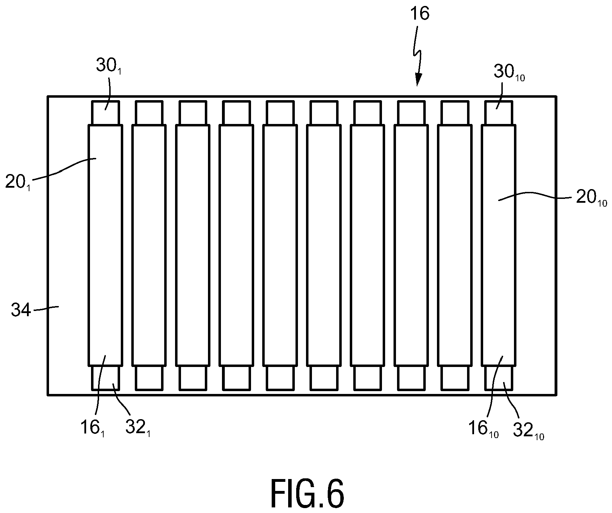

Fig. 6 shows an embodiment of a plurality of optical components 16₁ to 16₁₀ which are arranged on a common substrate 34. Each of the optical components 16₁ to 16₁₀ may comprise a component substrate and a photodiode layer structure 20₁ to 20₁₀ as described before. Each of the optical components 16₁ to 16₁₀ may be assigned to one or a plurality of light emitting devices (not shown), e.g. an array of VCSELs.

Fig. 6 also shows contacts 30₁ to 30₁₀ which may be p-contacts, and contacts 32₁ to 32₁₀ which may be n-contacts for contacting the photodiode layer structures 20₁ to 20₁₀ of the optical components 16₁ to 16₁₀. The contacts 30₁ to 30₁₀ and 32₁ to 32₁₀ maybe arranged on sides of the optical component 16.

In all embodiments described above, the thickness of the photodiode layer structure 20 is as thin as possible in order to keep the absorption of the light passing through the photodiode layer structure 20 as low as possible. In further embodiments, the photodiode layer structure 20 may be such that it does not or as little as possible influence the beam path of the light emitted by the light emitting device 12.

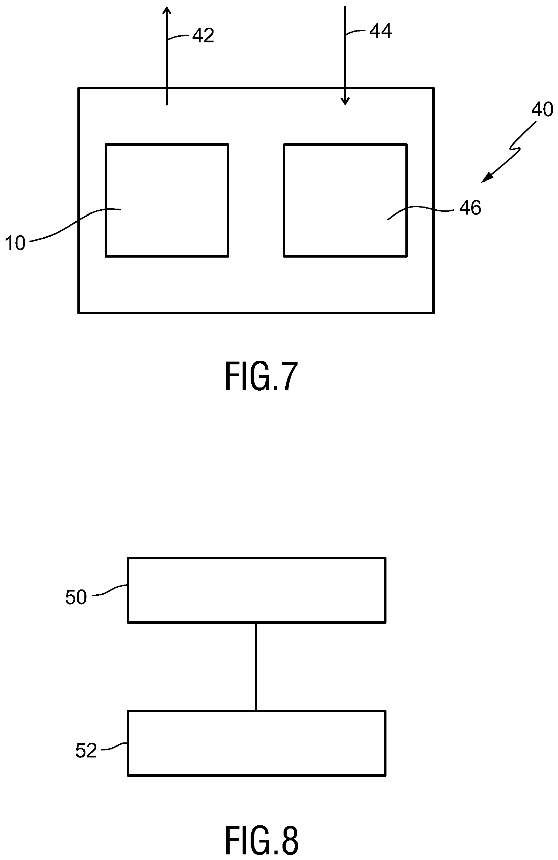

Fig. 7 shows a sketch of an optical sensor 40. The optical sensor device 40 comprises a light source device 10 as described above including the optical component 16. The light source device 10 emits light through the optical component 16 including the photodiode layer structure, according to an arrow 42. According to an arrow 44, the optical sensor device 40 receives light which is light emitted by the light source device 10 and reflected by an object (not shown) via a photodetector 46. The optical sensor device 40 may be a distance sensor, a velocity sensor, a particle detecting sensor etc.

Fig. 8 shows a flowchart of a method of manufacturing an optical component like the optical component 16 described above.

The method comprises a step 50 of providing the component substrate 18 of semiconductor material. The method further comprises a step 52 of monolithically integrating the photodiode layer structure 20 with the component substrate 18.

The step 52 of monolithically integrating the photodiode layer structure 20 with the component substrate 18 may comprise forming, e.g. growing or depositing the photodiode layer structure 20 on the component substrate 18 and etching the photodiode layer structure 20 and the component substrate 18 to a desired shape of the surface of the optical component 16. In this way, the photodiode layer structure 20 and the component substrate 18 merge into one another to form the optical component 16.

In an alternative embodiment, the component substrate 18 may be formed with a surface shape according to the desired optical function of the optical component 16, and subsequently, the photodiode layer structure 20 is formed on one of the surfaces of the component substrate 18, as described, for example, for the embodiments in Fig. 4 or 5.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. Optical component, comprising
a component substrate (18) of semiconductor material, the component substrate (18) being at least partially transparent for light in an operational spectral range, and
a photodiode layer structure (20) monolithically integrated with the component substrate (18) and being transparent in the operational spectral range.

2. Optical component of claim 1, wherein the component substrate (18) has a light entrance side (24) and a light exit side (22), wherein the photodiode layer structure (20) is monolithically integrated with the component substrate (18) on one of the light exit side (22) and the light entrance side (24) of the component substrate (18).

3. Optical component of claim 2, wherein the photodiode layer structure (20) exhibits a curved lens surface shape on the one of the light entrance side (24) and the light exit side (22) of the component substrate (18).

4. Optical component of claim 2, wherein the photodiode layer structure (20) exhibits a diffractive grating surface shape or diffusor surface shape on the on the one of the light entrance side (24) and the light exit side (22) of the component substrate (18).

5. Optical component of claim 1, wherein the photodiode layer structure (20) is grown or deposited on the component substrate (18).

6. Optical component of claim 1, wherein the photodiode layer structure (20) comprises the semiconductor material of the component substrate (18).

7. Optical component of claim 1, wherein the semiconductor material comprises a compound semiconductor material.

8. Optical component of claim 5, wherein the compound semiconductor material comprises GaAs including compounds thereof.

9. Optical component of claim 1, wherein the photodiode layer structure (20) is a thin film structure.

10. Light source device, comprising a light emitting device (12) configured to emit light in an operational spectral range, and an optical component (16) according to any one of claims 1 to 9, wherein the optical component (16) is arranged to receive and transmit light emitted by the light emitting device (12), wherein the photodiode layer structure (20) is arranged such with respect to the light emitting device (12) such that light emitted by the light emitting device (12) passes through the photodiode layer structure (20).

11. Light source device of claim 10, wherein the light emitting device (20) is a laser diode.

12. Light source device of claim 11, wherein the laser diode is a Vertical Cavity Surface Emitting Laser.

13. Optical sensor device, comprising a light source device (10) of any one of claims 10 to 12.

14. Method of manufacturing an optical component (16), comprising
providing a component substrate (18) of semiconductor material, the component substrate (18) being at least partially transparent for light in an operational spectral range, and
monolithically integrating a photodiode layer structure (20) with the component substrate (18), wherein the photodiode layer structure (20) is transparent in the operational spectral range.

15. Method of claim 14, wherein the step of monolithically integrating the photodiode layer structure (20) comprises forming the photodiode layer structure (20) on the component substrate (18) and etching the photodiode layer structure (20) to a desired shape of a surface of the optical component (16).
